## Europäisches Patentamt
## European Patent Office
## Office européen des brevets

(11) Veröffentlichungsnummer: **0 040 263**
**B1**

(12) # EUROPÄISCHE PATENTSCHRIFT

(45) Veröffentlichungstag der Patentschrift:
06.11.85

(51) Int. Cl.⁴: **H 01 L 29/78, H 01 L 29/10, H 01 L 29/36**

(21) Anmeldenummer: **80108109.2**

(22) Anmeldetag: **22.12.80**

(54) Isolierschicht-Feldeffekttransistor.

(30) Priorität: **17.05.80 DE 3018988**

(43) Veröffentlichungstag der Anmeldung:
**25.11.81 Patentblatt 81/47**

(45) Bekanntmachung des Hinweises auf die Patenterteilung:
**06.11.85 Patentblatt 85/45**

(84) Benannte Vertragsstaaten:
**DE FR GB IT NL**

(56) Entgegenhaltungen:
US - A - 3 513 364
US - A - 3 814 992
US - A - 4 017 888
US - A - 4 021 835

ELECTRONIC ENGINEERING, Band 48, Nr. 575, Januar 1976, Seiten 41-43, London, G.B. H.RUNGE: "Threshold voltage shift of MOS transistors by ion implantation"
IBM JOURNAL OF RESEARCH AND DEVELOPMENT, Band 19, Nr. 1, Januar 1975, Seiten 50-59, New York, USA V.L. RIDEOUT et al.: "Device design considerations for ion implanted n-channel MOSFETs"
1974 INTERNATIONAL ELECTRON DEVICES MEETING, 9.-11. Dezember 1974, Technical Digest 1974, Seiten 550-553, New York, USA W.S. JOHNSON et al.: "Design of short-channel ion -implanted MOSFETS with relatively deep junctions"

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Fritz, Günter, Adam, Dr., Furtwänglerstrasse 10, D-7800 Freiburg i. Br. (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

**Beschreibung**

Die Erfindung beschäftigt sich mit einem Isolierschicht-Feldeffekttransistor, wie er aus «IEDM Technical Digest» (1978) Seiten 26 bis 29, (1979), Seiten 30 bis 33 und «1980 IEEE International Circuits Conference, Digest of technical Papers» Seiten 60 und 61, bekannt ist. Der Transistor wird dort als Buried Channel MOS-FET bezeichnet.

Isolierschicht-Feldeffekttransistoren dieser Art werden unter Anwendung der Si-Gate-Technologie zur Herstellung der Gate-Elektrode und unter Anwendung der Ionenimplantation gefertigt, um die Dotierungen in der erforderlichen Konzentration in den Kanalbereich einzubringen. Dabei wird vorzugsweise ein solcher Dotierungskonzentrationsverlauf eingestellt, dass das Dotierungsmaximum unter der Substratoberfläche liegt, so dass eine «vergrabene Kanalzone» erhalten wird. Dies hat den Vorteil, dass die Ladungsträgerbeweglichkeit weitgehend ungestört von der Oberfläche ist und der grösseren Beweglichkeit im Inneren des Halbleiterkörpers entspricht. Da ausserdem relativ hochohmiges Substratmaterial verwendet wird, können schnelle logische integrierte Schaltungen realisiert werden.

Die Erfindung geht von dem Gedanken aus, die Schaltgeschwindigkeit und damit auch die Taktfrequenz solcher Isolierschicht-Feldeffekttransistoren noch weiter dadurch zu erhöhen, dass zwischen das Substrat und die Source-Zone eine Vorspannung unter Verwendung eines besonderen Substratanschlusses angelegt wird, die bezogen auf das Potential der Source-Zone einen solchen Wert hat, dass sie wie eine Sperrspannung zwischen Source-Zone und Substrat wirkt. Ein solcher Isolierschicht-Feldeffekttransistor hätte bereits den Vorteil, dass die technologischen Schwierigkeiten bei der Realisierung von P+-dotierten Gate-Elektroden auf N-Kanal-Si-Gate-Feldeffekttransistoren vermieden werden.

Weitere Vorteile wären:

– Verringerung aller parasitären PN-Übergangs-Kapazitäten,
– die Möglichkeit zur Einstellung einer kleinen effektiven Anreicherungs-Schwellenspannung,
– Anhebung der Kanalbeweglichkeit,
– Anhebung bzw. Eliminierung der sogenannten Punchthrough-Spannung auch bei sehr kurzen Kanälen und
– eine drastische Anhebung der Feldschwellenspannung.

Die beträchtliche Erhöhung der Feldschwellenspannung würde nun aber bei Verzicht auf einen Teil dieser erhöhten Feldschwellenspannung die Möglichkeit für weitere vorteilhafte technologische Massnahmen eröffnen.

Die übliche, die Substratoberflächenkonzentration erhöhende Feldimplantation ausserhalb des aktiven Bereichs des Isolierschicht-Feldeffekttransistors mittels Dotierungen vom Leitungstyp des Substrats, die für eine ausreichend grosse Feldschwellenspannung sonst erforderlich ist, könnte nämlich weggelassen werden. Dies ergibt den Vorteil einer Verringerung der erhöhten Randkapazitäten zwischen dem Feldimplantationsbereich einerseits und der Source-Zone und der Drain-Zone andererseits und einer Verringerung der parasitären Kapazitäten zwischen den mit den Zonen kontaktierten Leiterbahnen und dem Substrat. Damit wird eine weitere Erhöhung der Schaltkreisgeschwindigkeit erreicht.

Die Erfindung macht Gebrauch von den vorstehenden Erwägungen und betrifft einen Isolierschicht-Feldeffekttransistor gemäss dem Oberbegriff des Anspruchs 1, wie er aus der US-A 4 021 835 bekannt ist. Bei diesem Feldeffekttransistor beträgt die Dotierungskonzentration des Substrats im Kanalbereich $2.10^{15}$cm$^{-3}$.

Aufgabe der Erfindung ist die Weiterbildung eines solchen Isolierschicht-Feldeffekttransistors mit noch weiter verringerten Kapazitäten und zugleich erhöhter Drain-Substrat-Abbruchspannung.

Diese Aufgabe wird erfindungsgemäss dadurch gelöst, dass die Dotierungskonzentration des Substrats im Kanalbereich weniger als oder gleich $10^{15}$cm$^{-3}$ beträgt und dass ausserhalb des Kanalbereichs und ausserhalb der Source-Zone und der Drain-Zone in die Substratoberfläche Dotierungen vom anderen Leitungstyp in einer solchen Dosis eingebracht werden, dass die dadurch entstehende Verarmungsschicht oberhalb von etwa der halben Substratspannung ausgeräumt ist, welche bezogen auf das Potential der Source-Zone einen solchen Wert hat, dass sie wie eine Sperrspannung zwischen Source-Zone und Substrat wirkt, und die über einen Substratanschluss an das Substrat anlegbar ist.

Die Vorspannung kann über einen zusätzlichen Kontakt am Substrat entsprechend der US-PS 3 284 723 oder der DE-AS 2 042 586 angelegt werden. Es können auch auf jeder integrierten Schaltung die erforderlichen Vorspannungen über eine mitintegrierte Spannungsversorgungsschaltung erzeugt werden. Die Erzeugung mehrerer Vorspannungen über eine mitintegrierte Spannungsversorgungsschaltung erzeugt werden. Die Erzeugung mehrerer Vorspannungen ist insbesondere bei der Anwendung des Isolierschicht-Feldeffekttransistors nach der Erfindung auf integrierte CMOS-Schaltungen dann erforderlich, wenn die Anwendung auf beide Kanaltypen der CMOS-Schaltung erfolgen soll. In diesem Fall erhält das Substrat der p-Kanal-Feldeffekttransistoren ein anderes Potential und auch von unterschiedlichem Vorzeichen als das Substrat der n-Kanal-Feldeffekttransistoren.

Grundsätzlich sind bei einem Isolierschicht-Feldeffekttransistor nach der Erfindung in den Kanalbereichen dotierende Verunreinigungen in einer solchen Menge eingebracht, dass die implantierte Kanalzone (n-Leitungstyp bei n-Kanal) mit einer grossen, aber noch unter der Abbruchspannung liegenden Substratvorspannung bis zur Siliciumoberfläche ausgeräumt wird. Bei einem n-Kanal bewirkt dann eine positive Gatespannung das Einfliessen von Elektronen aus der Source-Zone in den Kanal, so dass durch das An-legen der Substratvorspannung ein Anreiche-rungsbetrieb möglich ist. Bei den bekannten Iso-lierschicht-Feldeffekttransistoren mit «vergrabe-ner Kanalzone» erfolgt dagegen die Ausräumung der Kanalzone aufgrund der relativ grossen Elektronenaustrittsarbeit des $p^+$-Gatematerials.

Eine weitere Verringerung der parasitären Kapazitäten und gleichzeitig eine Erhöhung der Drain-Substrat-Abbruchspannung wird dadurch erreicht, dass ausserhalb des Kanalbereichs und ausserhalb der Zonen in die Substratoberfläche Dotierungen vom Leitungstyp der Zonen in einer solchen Dosis eingebracht sind, dass die dadurch entstehende umdotierte leitende Schicht schon aufgrund etwa der halben Substratvorspannung ausgeräumt ist.

Die Erhöhung der Drain-Substrat-Abbruchspannung ergibt sich dabei durch eine «Planarisierung» der Raumladungszonen, d.h. durch Einebnung der Felstärkenverteilung innerhalb dieser Raumladungszone.

Die Dotierung der Halbleiteroberfläche im Feldbereich, d.h. ausserhalb des Kanalbereichs und ausserhalb der Zonen, ist auf den inneren Teil der die Zonen enthaltenden Substratoberfläche zu beschränken und darf nur bis zu einem gewissen Abstand (50 bis 100 μm) zum Rand des Halbleiterplättchens hin erfolgen. Vorzugsweise wird dazu eine maskierte Ionenimplantation an-gewendet.

Die maximale Nettokonzentration $N_{DF}$ der im-plantierten Dotierungen innerhalb des Feldbe-reichs soll nach einem eventuell erforderlichen zusätzlichen Diffusionsschritt nicht wesentlich höher liegen als die Substratkonzentration $N_{AS}$.

Bei der Realisierung eines N-Kanal-Isolierschicht-Feldeffekttransistors nach der Erfindung werden gemäss einem bevorzugten Ausführungsbeispiel nicht nur in den Kanalbereich eines P-dotierten Substrats N-dotierende Verunreinigungen in einer Konzentration von weniger als $10^{12} cm^{-2}$ durch Ionenimplantation eingebracht, sondern auch noch in einem besonderen mas-kierten Ionenimplantationsprozess ausserhalb des Kanalbereichs und ausserhalb der Zonen in die Substratoberfläche Dotierungen vom Leitungstyp der Zonen in einer solchen Dosis eingebracht, dass die dadurch entstehende Verarmungsschicht oberhalb von etwa der halben Substratspannung ausgeräumt ist. Dies kann ohne weiteres auch ohne Berechnungen anhand einiger Versuche ermittelt werden.

Somit wird ein P-Kanal-Isolierschicht-Feldeffekttransistor erhalten, wenn in den Kanalbereich eines N-dotierten Substrats P-dotierende Verunreinigungen in einer Konzentration von weniger als etwa $10^{12} cm^{-2}$ implantiert worden sind.

Bei einem n-Kanal-Isolierschicht-Feldeffekttransistor nach der Erfindung soll an das Substrat eine bezogen auf das Potential der Source-Zone negative Spannung angelegt werden, die dem Betrage nach grösser als etwa 10 V sein sollte.

Die Erfindung wird im folgenden anhand der Zeichnungen erläutert,

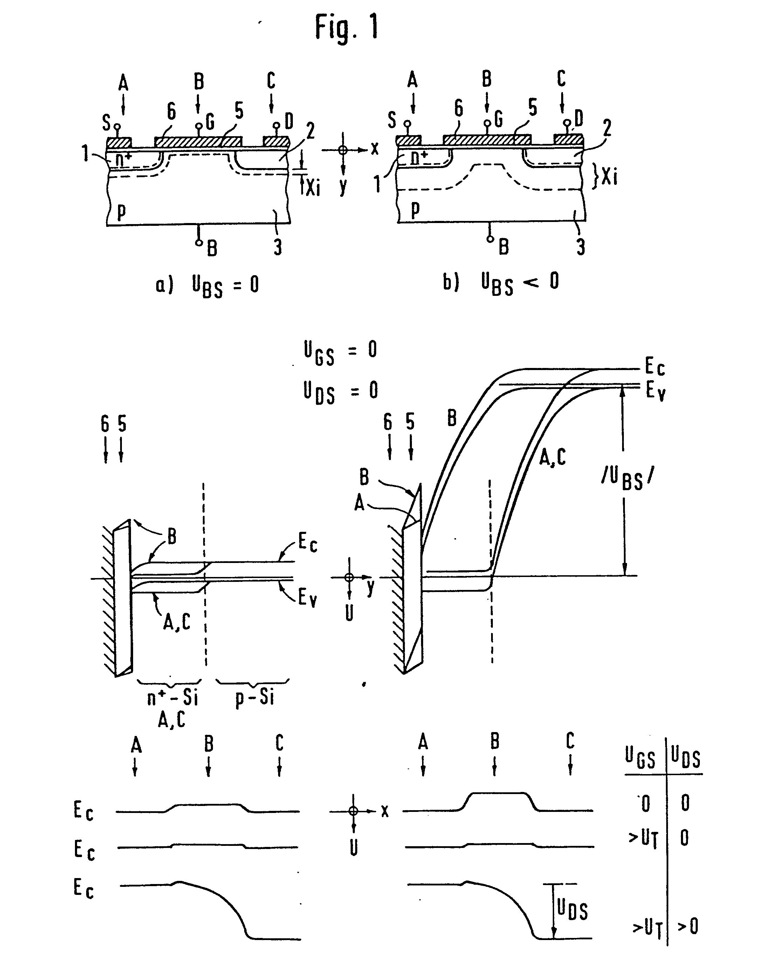

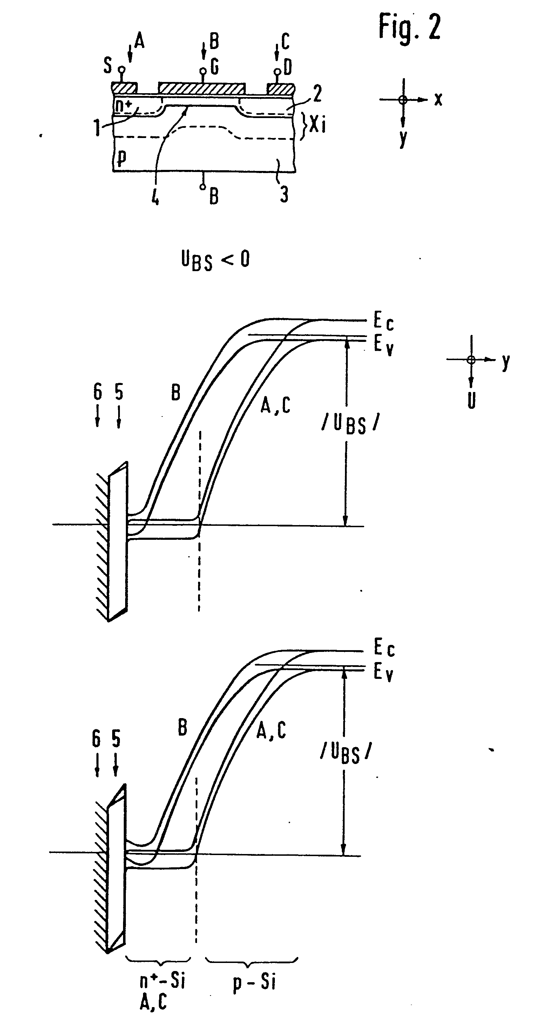

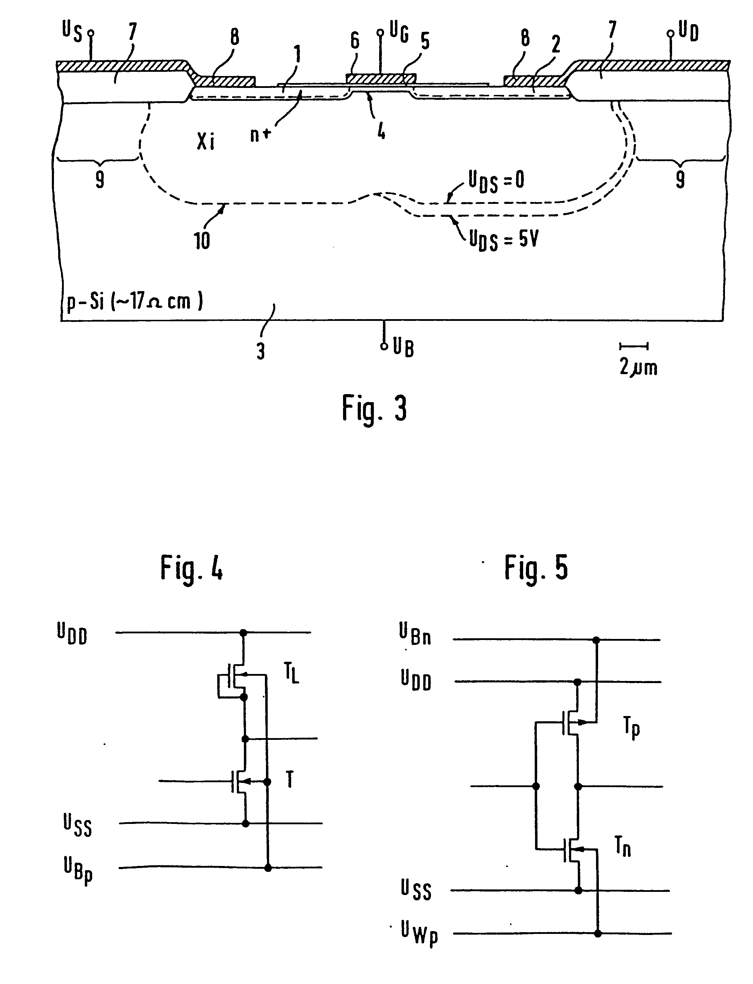

deren Fig. 1 zur Veranschaulichung der Potentialverhältnisse dient, für den Fall, dass keine dotierende Verunreinigung in den Kanalbereich eingebracht worden ist,

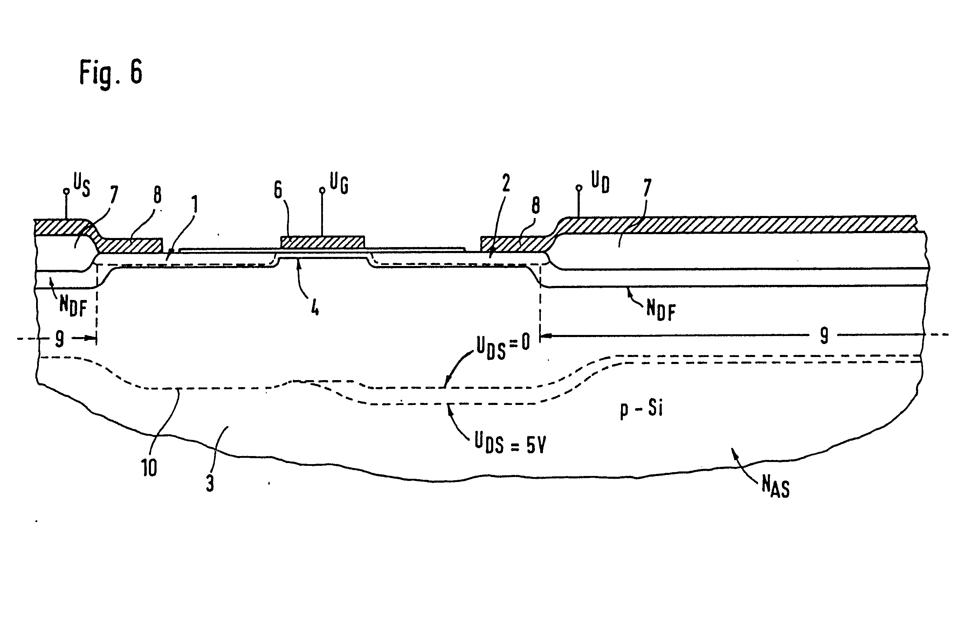

deren Fig. 2 die Potentialverhältnisse veranschaulicht, für den Fall, dass entsprechend der Erfindung in den Kanalbereich des Substrats dotierende Verunreinigungen implantiert worden sind,

deren Fig. 3 eine Ausführungsform eines integrierten Isolierschicht-Feldeffekttransistors nach der Erfindung in üblicher Teilschnittansicht zeigt,

deren Fig. 4 und 5 Grundschaltungen enthal-ten, in denen Isolierschicht-Feldeffekttransisto-ren nach der Erfindung Verwendung finden und in

deren Fig. 6 in Teilschnittansicht einer integrierten Festkörperschaltung eine bevorzugte Weiterbildung des Isolierschicht-Feldeffekttransistors nach der Erfindung dargestellt ist.

Die Fig. 1 dient zur Erläuterung der Wirkung einer Substratvorspannung $U_{BS}$ bei einem her-kömmlichen n-Kanal-Isolierschicht-Feldeffekt-transistor ohne eine Einbringung von dotierenden Verunreinigungen in den Kanalbereich unter der Gate-Elektrode 6, welche auf dem Gate-Oxid 5 zwischen der Source-Zone 1 und der Drain-Zone 2 aufgebracht ist. An das Substrat 3 ist ein Kontakt B angebracht worden.

Die linke Hälfte der Fig. 1 bezieht sich auf den Fall einer Substratvorspannung von $U_{BS} = 0$, während die rechte Hälfte der Fig. 1 sich mit dem Fall b einer Substratvorspannung von $U_{BS} < 0$ be-schäftigt.

Für diese beiden Fälle sind in der mittleren Reihe der Fig. 1 die Bändermodelle angegeben, wobei die Gate-Source-Spannung $U_{GS} = 0$ und die Drain-Source-Spannung $U_{DS} = 0$ angenommen wurden. Die Leitungsband-Niveaus $E_C$ und Va-lenzband-Niveaus $E_V$ sind entlang den in der obersten Reihe angegebenen Schnittlinien A, B und C senkrecht zur Halbleiteroberfläche angegeben.

In gleicher Weise sind in der letzten Reihe der Fig. 1 die Leitungsbänder $E_C$ für die rechts dane-ben angegebenen drei Fälle gezeigt, wobei $U_T$ die Schwellenspannung bedeutet.

Die Fig. 2 veranschaulicht für den Fall eines n-Kanal-Isolierschicht-Feldeffekttransistors mit zusätzlicher n-dotierender Implantation des Ka-nalbereichs zwei Ausführungsbeispiele eines Iso-lierschicht-Feldeffekttransistors nach der Erfin-dung. Die mittlere Abbildung zeigt die Energie-bänder für einen Isolierschicht-Feldeffekttransi-stor, bei dem das Konzentrationsmaximum der implantierten Verunreinigungen an der Oxid-Silicium-Grenzfläche liegt, während die untere Abbildung für den Fall gilt, dass das Maximum der Dotierungskonzentration unterhalb der Oxid-Silicium-Grenzfläche liegt. Deutlich ist in der unteren Abbildung für den Schnitt B das für den «vergrabenen Kanal» typische Minimum der Bänder erkennbar.

Die Fig. 3 zeigt etwa massstabgetreu in üblicher Schnittdarstellung einen n-Kanal-Silicium-Gate-Feldeffekttransistor mit kurzem Kanal nach der Erfindung, in dessen Kanalbereich 4 n-dotierende Verunreinigungen implantiert worden sind. Um den aktiven Bereich des Feldeffekttransistors angrenzend an die Source-Zone 1 und die Drain-Zone 2 ist eine Dickoxidschicht 7 unter Anwendung einer mittels Siliciumnitrid maskierten Oxidation hergestellt worden. Auf dieser Dickoxidschicht 7 verlaufen die gleichzeitig mit der Gate-Elektrode 6 erzeugten Leitbahnen 8 aus polykristallinem Silicium. Es ist üblich, Isolierschicht-Feldeffekttransistoren einer integrierten Schaltung mit einem Implantationsbereich 9 zu umgeben, der mittels eines Ionenimplantationsprozesses von p-dotierenden Verunreinigungen hergestellt wird. Dieser Feldimplantationsbereich 9 kann jedoch entfallen, falls eine Substratvorspannung angelegt wird.

Die Grenzen 10 der sich in p-leitenden Siliciumsubstrat von etwa $17\Omega\cdot$cm ausbreitenden Raumladungszone Xi sind gestrichelt für die Drain-Source-Spannungen von 0 bzw. 5V angegeben. Offensichtlich ist die Verschiebung dieser beiden Grenzen in einem solchen hochohmigen Material für die betreffende Spannungsänderung von $\Delta$ $U_{DS}$ = 5V sehr klein, was einer sehr kleinen Ladungsänderung $\Delta$ Q und daher einer sehr kleinen kapazitiven Belastung ($\Delta$ C = $\Delta$ Q/$\Delta$ $U_{DS}$) entspricht.

Die Fig. 4 zeigt die Spannungsversorgung eines Inverters mit einem Lasttransistor T1 und einem Invertertransistor T. Die Spannungsversorgung erfolgt über eine gesonderte Vorspannungsleitung, an die die Spannung $U_{Bp}$ angelegt wird. Der Lasttransistor T1 erhält eine zusätzliche Implantation von Verunreinigungen des Leitungstyps der Source- bzw. Drain-Zone, um zu gewährleisten, dass dieser Lasttransistor T1 im Verarmungsbetrieb arbeitet.

Die Fig. 5 zeigt das Schaltbild eines CMOS-Inverters mit einem p-Kanal und einem n-Kanal-Feldeffekttransistor, beide nach der Erfindung ausgebildet. Die Substrate der beiden Feldeffekttransistoren Tp und Tn erhalten ihre Vorspannung über zwei Vorspannungsleitungen, an die je eine Vorspannung $U_{Bn}$ und $U_{Wp}$ angelegt werden, wie die Fig. 5 zeigt. Da die Substratvorspannung bzw. die Substratvorspannungen nur durch Sperrströme belastet wird bzw. werden, ist es auch möglich, die Substratvorspannungen bzw. Substratvorspannung auf dem Halbleiterplättchen durch geeignete Vorspannungsschaltungen zu erzeugen.

Die Fig. 6 zeigt in gleicher Schnittdarstellung und gleichen Bezugszeichen wie die der Fig. 3 einen n-Kanal-Feldeffekttransistor entsprechend einer Weiterbildung der Erfindung. In ein mit einem Kontakt versehenes p-leitendes Siliciumsubstrat mit einer Substratdotierung $N_{AS}$ entsprechend einem spezifischen Widerstand zwischen etwa 10 bis 50$\Omega\cdot$cm werden die Source-Zone 1 und die Drain-Zone 2 eingebracht. Im übrigen wird bis auf die sehr schwache N-Dotierung $N_{DF}$ im Feldimplantationsbereich 9 in gleicher Weise bei der Herstellung wie beim Ausführungsbeispiel gemäss der Fig. 3 verfahren. Bei einer Feldimplantation ist aber zur Verhütung von störenden Randeffekten darauf zu achten, dass diese Implantation auf das Innere der Oberfläche eines integrierten Schaltkreises beschränkt sein muss und sich nur bis zu einem gewissen Abstand (50 bis 100 µm) vom Plättchenrand erstrekken sollte. Die maximale Nettokonzentration $N_{DF}$ der implantierten Dotierung soll nach einem eventuell erforderlichen zusätzlichen Diffusionsschritt nicht wesentlich höher liegen als die Substratkonzentration $N_{AS}$.

Obwohl die Erfindung mit grösstem Vorteil bei einem Isolierschicht-Feldeffekttransistor mit «vergrabenem Kanal» nach den eingangs erwähnten Literaturstellen anwendbar ist, ergeben sich bereits beträchtliche Verbesserungen selbst bei Isolierschicht-Feldeffekttransistoren, welche das anhand der Fig. 2 erläuterte Minimum im Leitungsband nicht aufweisen, sondern in deren Kanalbereich lediglich Dotierungen mit einem Dotierungskonzentrationsverlauf eingebracht worden sind, bei dem kein ausgeprägtes Minimum im Leitungsband ausbildet, wie die mittlere Abbildung der Fig. 2 veranschaulicht.

## Patentansprüche

1. Isolierschicht-Feldeffekttransistor mit einem von derjenigen Oberfläche eines einen ersten Leitungstyps aufweisenden Silicium-Substrats (3), in die die Source-Zone (1) und die Drain-Zone (2) eingelassen sind, her dotierten Kanalbereich (4), in den dotierende Verunreinigungen des anderen Leitungstyps mit einer Oberflächenkonzentration von mehr als die Dotierungskonzentration des Substrats (3) an der Substratoberfläche eingebracht sind, dadurch gekennzeichnet,
– dass die Dotierungskonzentration des Substrats (3) im Kanalbereich (4) weniger als oder gleich $10^{15}$cm$^{-3}$ beträgt und
– dass ausserhalb des Kanalbereichs (4) und ausserhalb der Source-Zone (1) und der Drain-Zone (2) in die Substratoberfläche Dotierungen vom anderen Leitungstyp in einer solchen Dosis eingebracht sind, dass die dadurch entstehende Verarmungsschicht oberhalb von etwa der halben Substratvorspannung ausgeräumt ist, welche bezogen auf das Potential der Source-Zone (1) einen solchen Wert hat, dass sie wie eine Sperrspannung zwischen Source-Zone (1) und Substrat (3) wirkt, und die über einen Substratanschluss (B) an das Substrat (3) anlegbar ist.

2. Feldeffekttransistor nach Anspruch 1, dadurch gekennzeichnet, dass in den Kanalbereich (4) eines p-dotierten Substrats (3) n-dotierende Verunreinigungen in einer Konzentration gleich oder kleiner als ca. $10^{12}$cm$^{-2}$ eingebracht sind.

3. Feldeffekttransistor nach Anspruch 1, dadurch gekennzeichnet, dass in den Kanalbereich (4) eines n-dotierten Substrats (2) p-dotierende Verunreinigungen in einer Konzentration von gleich oder kleiner als ca. $10^{12}$cm$^{-2}$ eingebracht sind.

4. Feldeffekttransistor nach einem der Ansprüche 1 bis 3, dadurch gekennzeichnet, dass die Dotierungen in die Substratoberfläche eines Halbleiterplättchens ausserhalb der Source- und Drain-Zonen (1, 2) und des Kanalbereiches (4) mit Abstand vom Plättchenrand eingebracht sind.

5. Verfahren zum Betrieb eines Feldeffekttransistors nach einem der Ansprüche 1 bis 4, dadurch gekennzeichnet, dass eine Substratspannung von grösser oder gleich 1,5mal der Betriebsspannung ($U_{DS}$) angelegt wird.

6. Verfahren nach Anspruch 5, dadurch gekennzeichnet, dass eine Substratvorspannung von mehr als 10 V angelegt wird.

## Claims

1. Insulated-gate field-effect transistor with a channel region (4) doped from that surface of a silicon substrate showing a first conductivity type into which the source-zone (1) and the drain-zone (2) are inserted and into which surface doping impurities of the other conductivity type with a surface concentration of more than the doping concentration of said substrate (3) at the substrate surface are introduced, characterized in
- that the doping concentration of said substrate (3) within said channel region (4) is less than or equal to $10^{15}$cm$^{-3}$ and
- that outside said channel region (4) and outside said source-zone (1) and said drain-zone (2) dopings of the other conductivity type are inserted into the surface of said substrate in such a dose rate that the thus resulting depletion layer is cleared above at approximately half the substrate biasing voltage which having such a value with respect to the potential of the source-zone (1) that said substrate bias voltage is acting as a reverse voltage between the source-zone (1) and the substrate (3) and which is applicable via a substrate terminal (B) to the substrate (3).

2. A field-effect transistor as claimed in claim 1, characterized in that into the channel region (4) of a p-doped substrate (3), n-doping impurities in a concentration equal to or less than approximately $10^{12}$cm$^{-2}$ are inserted.

3. A field-effect transistor as claimed in claim 1, characterized in that into said channel region (4) of an n-doped substrate (2) p-doping impurities in a concentration equal to or less than approximately $10^{-12}$cm$^{-2}$ are introduced.

4. A field-effect transistor as claimed in claims 1 to 3, characterized in that the dopings are introduced into the substrate surface of a semiconductor wafer outside the source- and drain-zones (1, 2) and the channel region (4) at a distance from the edge of said wafer.

5. Method of operating a field-effect transistor as claimed in claims 1 to 4, characterized in that a substrate voltage of higher than or equal to 1.5 times the supply voltage (UDS) is applied.

6. Method as claimed in claim 5, characterized in that a substrate bias voltage of more than 10 V is being applied.

## Revendications

1. Transistor à effet de champ à grille isolée comprenant une région de canal (4) dopée à partir de la surface d'un substrat de silicium (3) possédant un premier type de conductibilité, la zone de source (1) et la zone de drain (2) étant incluses dans ladite surface, dans lequel sont introduites des impuretés dopantes d'un autre type de conductibilité à une concentration de surface supérieure à la concentration de dopage du substrat (3), caractérisé en ce que la concentration de dopage du substrat (3) dans la région de canal (4) est inférieure ou égale à $10^{15}$cm$^{-3}$, et en ce que des dopages d'un autre type de conductibilité sont introduits à l'extérieur de la région de canal (4) et à l'extérieur de la zone de source (1) et de la zone de drain (2) à un niveau permettant d'éliminer les porteurs de charge de la région d'appauvrissement ainsi formée, au-dessus d'environ la moitié de la tension de polarisation du substrat, laquelle possède, par rapport au potentiel de la zone de source (1), une valeur telle qu'elle agit comme une tension de blocage entre la zone de source (1) et le substrat (3) et peut être appliquée au substrat (3) au moyen d'une borne de substrat (B).

2. Transistor à effet de champ conforme à la revendication 1, caractérisé en ce que, dans la région de canal (4) d'un substrat dopé P (3) sont introduites des impuretés dopantes N à une concentration égale ou inférieure à environ $10^{12}$cm$^{-2}$.

3. Transistor à effet de champ conforme à la revendication 1, caractérisé en ce que, dans la région de canal (4) d'un substrat dopé N (2) sont introduites des impuretés dopantes P à une concentration égale ou inférieure à environ $10^{12}$cm$^{-2}$.

4. Transistor à effet de champ conforme à l'une des revendications 1 à 3, caractérisé en ce que les dopages mis en place dans la surface du substrat d'une plaquette de semi-conducteur à l'extérieur des zones de source et de drain (1, 2) et de la région de canal (4) sont introduits en respectant un écartement par rapport au bord de la plaquette.

5. Méthode d'exploitation d'un transistor à effet de champ conforme à l'une des revendications 1 à 4, caractérisé en ce qu'une tension de substrat supérieure ou égale à 1, 5 fois la tension de fonctionnement ($U_{DS}$) est appliquée.

6. Méthode conforme à la revendication 5, caractérisée en ce qu'une tension de substrat supérieure à 10 V est appliquée.

# Fig. 1

a)  $U_{BS} = 0$    b)  $U_{BS} < 0$

$U_{GS} = 0$

$U_{DS} = 0$

0 040 263

Fig. 2

$U_{BS} < 0$

$E_c$
$E_v$

$/U_{BS}/$

$E_c$
$E_v$

$/U_{BS}/$

n+-Si
A,C

p-Si

9

Fig. 3

Fig. 4

Fig. 5

Fig. 6

0 040 263